# EUROPEAN PATENT APPLICATION

(11) **EP 3 992 262 A1**
(43) Date of publication of application: **04.05.2022**
(21) Application number: 20833624.8
(22) Date of filing: 25.06.2020
(51) Int. Cl.: C09J 109/02, C09J 163/00, C09J 11/04, C09J 7/20, C09J 7/30, C09J 7/40, H05K 3/28

(54) **ADHESIVE COMPOSITION, COVERLAY FILM COMPRISING SAME, AND PRINTED CIRCUIT BOARD**

(30) Priority: 25.06.2019 KR 20190075971
(71) Applicant: Doosan Corporation, Seoul 04563 (KR)
(72) Inventor: KIM, Sungmoon, Yongin-si, Gyeonggi-do 16858 (KR); PARK, Kwangseok, Yongin-si, Gyeonggi-do 16858 (KR); JEONG, Inki, Yongin-si, Gyeonggi-do 16858 (KR); PARK, Subyung, Yongin-si, Gyeonggi-do 16858 (KR)
(74) Representative: Isarpatent
(86) International application number: PCT/KR2020/008272
(87) International publication number: WO 2020/262980

(57) **Abstract**

The present invention relates to: an adhesive composition; a coverlay film comprising same; and a printed circuit board, wherein the adhesive composition comprises an epoxy resin, a binder resin containing at least one type of rubber, and an inorganic filler, and has a viscosity of at most 8,000 cps.

## Description

### Technical Field

The present disclosure relates to an adhesive composition, and a coverlay film and a printed circuit board, each comprising same.

### Background Art

A coverlay film is attached to a circuit pattern formation surface in order to protect a circuit pattern during the manufacturing process and use of the printed circuit board. Such a coverlay film includes a base and an adhesive layer.

Conventionally, an adhesive layer in a coverlay film is formed of an adhesive such as a formulation of an epoxy resin and a polyester, or a formulation of an epoxy resin and an acryl resin. However, adhesive layers in conventional coverlay films are poor in fluidity and filling properties (landfilling). Thus, when conventional coverlay films are applied to undulated printed circuit boards, voids between the coverlay films and the printed circuit boards require long time for removal thereof, which leads to an increase in manufacturing time. Moreover, the adhesive layer in conventional coverlay films is prone to forming a short circuit between circuit patterns on the printed circuit board due to the poor anti-migration property thereof, which degrades the reliability of the printed circuit board.

### Disclosure of Invention

### Technical Problem

An aspect of the present disclosure is to provide an adhesive composition capable of forming an adhesive layer superb in fluidity, filling property (landfilling), and anti-migration property, without degrading adhesiveness.

Another aspect of the present disclosure is to provide a coverlay film and a printed circuit board comprising the same, the coverlay film including the adhesive composition and allowing for a decrease in the time of a hot press process and an increase in reliability.

### Solution to Problem

In order to achieve the technical purposes, the present disclosure provides an adhesive composition comprising: an epoxy resin; a binder resin comprising at least one rubber; and an inorganic filler, and having a viscosity of 8,000 cps or less.

In addition, the present disclosure provides a coverlay film comprising: a base substrate; an adhesive layer disposed on one surface of the base substrate and formed of the adhesive composition; and a release film disposed on the adhesive layer.

Further, the present disclosure provides a printed circuit board comprising: a board body; and the coverlay film disposed on at least one surface of the board body.

### Advantageous Effects of Invention

The adhesive composition according to the present disclosure comprises an epoxy resin, a binder resin, and an inorganic filler, wherein the binder resin comprises at least one rubber, whereby the adhesive composition can form an adhesive layer superb in terms of adhesiveness, fluidity, filling properties (landfilling), migration resistance, discoloration resistance, heat resistance, moisture resistance, chemical resistance, and so on.

In addition, the coverlay film of the present disclosure comprises an adhesive layer formed of the above-described adhesive composition and as such, can enhance hot press process efficiency upon the manufacture of printed circuit boards and reduce defective rates in the printed circuit boards, thus contributing to an improvement in the reliability of the printed circuit boards.

### Brief Description of Drawings

FIG. 1 is a schematic cross-sectional view of a coverlay film according to a first embodiment of the present disclosure.

FIG. 2 is a schematic cross-sectional view of a coverlay film according to a second embodiment of the present disclosure.

FIG. 3 is a plot of viscosity changes with temperature in the adhesive compositions of Examples 1 and 6 and Comparative Example 1 as measured by a rheometer.

FIGS. 4(a) and 4(b) are images of printed circuit boards to which the coverlay films of Example 1 and Comparative Example 1 have been applied, respectively, comparing filling properties under the same condition.

FIGS. 5(a) and 5(b) are images of the surfaces of printed circuit boards to which the coverlay film of Example 1 and the control coverlay film (DC-200, Doosan Cooperation Electro-Materials) have been applied, respectively, comparing filling properties under the same condition.

### **Description for reference symbols

10A, 10B: Coverlay film, 11: Substrate
12: Adhesive layer, 13: Release film,
14: Surface protection film

### Best Mode for Carrying out the Invention

Below, a description will be given of the present disclosure.

### <Adhesive Composition>

An adhesive composition according to the present disclosure may comprise: an epoxy resin; a binder resin including at least one rubber; and an inorganic filler, and optionally a curing agent, a curing accelerator, an organic solvent, and an additive.

Individual ingredients of the adhesive composition according to the present disclosure will be elucidated, below.

### a) Epoxy resin

In the adhesive composition of the present disclosure, the epoxy resin, which is a thermosetting resin, forms a three-dimensional network structure after curing, thereby increasing adhesiveness of the coverlay film to the printed circuit board as well as improving heat-resistant reliability for the coverlay film due to the excellent heat resistance, waterproofness, and moisture resistance thereof. In addition, the epoxy resin exhibits excellent performances in terms of compatibility with other resins, mechanical strength, electric insulation, chemical resistance, dimensional stability, and moldabilityand.

An epoxy resin available for the present disclosure is a polymer bearing at least one intramolecular epoxide group, but no intramolecular halogen atoms, such as bromine. In addition, the epoxy resin may contain silicon, urethane, polyimide, polyamide, etc. within the molecule thereof in addition to bearing intramolecular phosphorous, sulfur, nitrogen atoms, etc.

No particular limitations are imparted into types of the epoxy resin. Examples of the epoxy resin include: bisphenol A-type epoxy resins, bisphenol F-type epoxy resin, and hydrogenated those thereof; glycidyl ether epoxy resins, such as phenol novolac epoxy resins, cresol novolac epoxy resins, etc.; glycidyl ester epoxy resins such as hexahydrophthalic acid glycidyl ester, dimer acid glycidyl ester, etc.; glycidyl amine epoxy resins such as triglycidyl isocyanutate, tetraglycidyl diaminodiphenylmethane, etc.; linear aliphatic epoxy resins such as epoxidized polybutadiene, epoxidized soybean oil, etc., with preference for bisphenol A-type epoxy resins, bisphenol F-type epoxy resins, phenol novolac epoxy resins, cresol novolac epoxy resins, biphenyl-type epoxy resins, and multifunctional epoxy resins. These resins may be used alone or in combination.

By way of example, the epoxy resin may be a multifunctional epoxy resin. Here, the multifunctional epoxy resin is an epoxy resin bearing two or more, specifically 2-5 epoxy groups per molecule and can confer electric insulation, heat resistance, chemical stability, toughness, and moldability on the adhesive layer.

Examples of the multifunctional epoxy resin include epoxy resins obtained by epoxidizing condensates of phenols or alkyl phenols and hydroxybenzaldehyde, phenol novolac epoxy resins, cresol novolac epoxy resins, phenol aralkyl epoxy resins, biphenyl-type epoxy resins, bisphenol A-type epoxy resins, bisphenol F-type epoxy resins, linear aliphatic epoxy resins, cycloaliphatic epoxy resins, heterocyclic epoxy resins, epoxy resins containing spiro rings, xyloc-type epoxy resins, multifunctional epoxy resins, naphthol novolac epoxy resins, novolac epoxy resins of bisphenol A/bisphenol F/bisphenol AD, glycidyl ether epoxy resins of bisphenol A/bisphenol F/bisphenol AD, bishydroxybiphenyl epoxy resins, dicyclopentadiene epoxy resins, and naphthalene epoxy resins, but are not limited thereto.

The epoxy equivalent in such epoxy resins is not particularly limited, but can enhance heat resistance and moldability in the composition as well as fluidity of the semi-cured product (e.g., adhesive layer of the coverlay film) from the adhesive composition when given a range of about 100 to 500 g/eq. Particularly, when the epoxy resin with an epoxy equivalent in the above-mentioned range is mixed with acrylic rubber, which is a kind of binder resins, the fluidity of the adhesive layer is maximized, making it possible for the adhesive layer of the coverlay film to fill a gap between circuits on the printed circuit board within a short time.

In the adhesive composition of the present disclosure, the content of the epoxy resin is not particularly limited. The epoxy resin may be contained in an amount of about 5 to 50 parts by weight, specifically in an amount of about 10 to 40 parts by weight, based on 100 parts by weight of the adhesive composition. In this regard, the adhesive composition has excellent fluidity, so that the adhesive layer is given a maximum filling property and exhibits further improved heat resistance.

### b) Binder resin

The adhesive composition of the present disclosure comprises a binder resin. The binder resin includes at least one rubber and imparts interlayer adhesiveness not only to induce the composition to become a film, but also to improve flexibility and crack resistance of the cured product (e.g., adhesive layer) after curing.

According to an embodiment, the binder resin contains nitrile-butadiene rubber and acrylic rubber. In this regard, the use ratio (mix ratio) of nitrile-butadiene rubber and acrylic rubber is not particularly limited and may be, for example, a weight ratio of 1 : 1.5-7. However, when the use ratio (mix ratio) of nitrile-butadiene rubber and acrylic rubber is within the above-stated range, the adhesive layer is controlled to range in viscosity from about 500 to 8,000 cps (specifically, about 1,000-8,000 cps, more particularly about 1,000-3,000 cps, even more particularly about 1,000-1,500 cps) at a temperature of 140-160°C (particularly about 150°C), which leads to maximizing the fluidity of the adhesive layer and enhancing the filling property of the adhesive layer upon hot pressing of the coverlay film. Particularly, the adhesive composition of the present disclosure can reduce a hot press process time about 5 to 6 folds, compared to conventional adhesive composition, thus enhancing the process efficiency. Moreover, being superb in terms of adhesiveness, heat resistance, and electric insulation as well as migration resistance and discoloration resistance in high temperature and high moisture conditions, the adhesive layer formed of the adhesive composition of the present disclosure can enhance reliability of the coverlay film.

In the binder resin of the present disclosure, the nitrile-butadiene rubber (NBR) is a synthetic rubber obtained as a copolymer of acrylonitrile and butadiene. When the coverlay film is temporarily attached to a printed circuit board and then hot pressed at a temperature of about 140-160°C under a surface pressure of 10-100 kgf/cm² and a linear pressure of about 2-20 kN, chemical coupling reactions occurs between nitrile-butadiene rubber components to regulate the fluidity of the adhesive layer, thereby enhancing migration resistance and discoloration resistance in the adhesive layer and imparting adhesiveness, heat resistance, and electric insulation to the adhesive layer.

The content of acrylonitrile in nitrile-butadiene is not particularly limited and may be, for example, in the range of about 25 to 45 % by weight. When the content of acrylonitrile in the nitrile-butadiene rubber is in the above-stated range, the binder resin may react with the epoxy resin to achieve excellent heat resistance and can secure filling property and processability because its reaction rate is easy to control.

According to an embodiment, the nitrile-butadiene rubber may be an acrylonitrile-butadiene having a carboxyl group at the end and/or side chain thereof (hereinafter referred to as "carboxyl-bearing NBR"). The carboxyl-bearing NBR has a carboxyl group, and thus, may increase the stability of the adhesive composition and enhances compatibility with other components and the processability of the adhesive composition. In addition, the carboxyl-bearing NBR increases the polarity of the adhesive composition, resulting in an improvement in physical properties including adhesiveness, moisture resistance, heat resistance, and so on.

No particular limitations are imparted to the content of carboxyl group in the carboxyl-bearing NBR. For example, the content may range about 0.5 to 2 % by weight. In this regard, the content of acrylonitrile in the carboxyl-bearing NBR may be about 25 to 45 % by weight.

In the binder resin of the present disclosure, the content of nitrile-butadiene rubber is not particularly limited. When a content amount of nitrile-butadiene rubber is too small, it is difficult to achieve excellent heat resistance and adhesiveness. On the other hand, too large a content of nitrile-butadiene rubber makes it difficult to control filling. Thus, the content of nitrile-butadiene rubber ranges from about 5 to 25 parts by weight, specifically, from 5 to 18 parts by weight, based on 100 parts by weight of the adhesive composition. In this regard, the adhesive layer can enhance migration resistance, discoloration resistance, adhesiveness, heat resistance, and electric insulation.

In the binder resin of the present disclosure, the acrylic rubber is a synthetic rubber including (meth)acrylic acid ester-derived repeat units. When the coverlay film is temporarily attached to a printed circuit board and then hot pressed at a temperature of about 150-190°C under a surface pressure of about 10-100 kgf/cm² and a linear pressure of 2-20 kN, the acrylic rubber remains non- or semi-crosslinked in the adhesive layer, maximizing the fluidity of the adhesive layer, together with epoxy resin, and is crosslinked upon thermal curing of the adhesive layer, thereby enhancing adhesiveness, shear bond, and elasticity in the adhesive layer.

So long as it is known in the art, any acrylic rubber may be used in the art, without particular limitations thereto. Examples of the acrylic rubber include homopolymers containing (meth)acrylic acid ester-derived repeat units; copolymers containing (meth)acrylic acid ester-derived repeat units and acrylonitrile-derived units; and copolymers containing (meth)acrylic acid ester-derived repeat units and chlorine atom-bearing monomer-derived repeat units. Moreover, the copolymers may further contain repeat units derived from monomers such as acrylic acid, methacrylic acid, glycidyl acrylate, glycidyl methacrylate, etc., in addition to the aforementioned repeat units. Here, (meth)acrylic acid ester means acrylic acid ester or methacrylic acid ester.

Examples of the (meth)acrylic acid alkylester include (meth)acrylic acid alkylester containing C1-C20 alkyl groups, such as ethyl(math)acrylate, n-propyl(math)acrylate, n-butyl(math)acrylate, isobutyl(math)acrylate, sec-butyl(math)acrylate, n-hexyl(math)acrylate, 2-ethyl(meth)hexylacrylate, n-octyl(meth)acrylate, isooctyl(math)acrylate, n-nonyl(math)acrylate, n-decyl(math)acrylate, etc.; conjugated diene monomers of 4-6 carbon atoms, such as butadiene, etc.; and vinyl ethers, such as vinyl methyl ether, vinyl ethyl ether, vinyl propyl ether, etc. These compounds may be used alone or in combination.

The binder resin of the present disclosure may further include at least one of a natural rubber; and a synthetic rubber such as styrene-butadiene rubber (SBR), acrylate-butadiene rubber, acrylonitrile-butadienestyrene rubber, and so on, in addition to the aforementioned nitrile-butadiene rubber (NBR) and acrylic rubber. The at least one rubber (exclusing NBR and acrylic rubber) may be used in an amount of about 20 % by weight or less, particularly in an amount of about 0.01-15 % by weight, based on the total weight of the binder resin.

In the adhesive composition, the content of the binder resin is not particularly limited, but may be about 30 to 60 parts by weight, specifically about 40 to 50 parts by weight, based on 100 parts by weight of the adhesive composition. In this regard, the adhesive composition has excellent fluidity, thus giving the adhesive layer a maximum filling property and enhanced heat resistance.

### (c) Inorganic filler

The adhesive composition according to the present disclosure comprises an inorganic filler. The inorganic filler can adjust melt viscosity as well as enhancing mechanical properties such as insulation, heat resistance, strength, etc., and low stress.

Non-limiting examples of the inorganic filler available in the present disclosure include silica, such as natural silica, fused silica, amorphous silica, crystalline silica, and so on, aluminum hydroxide (ATH), boehmite, alumina, talc, glass (e.g., spherical glass), calcium carbonate, magnesium carbonate, magnesia, clay, calcium silicate, magnesium oxide (MgO), titanium oxide, antimony oxide, glass fiber, aluminum borate, barium titanate, strontium titanate, calcium titanate, magnesium titanate, bismuth titanate, titania (e.g, TiO₂), barium zirconate, calcium zirconate, boron nitride, silicon nitride, talc, and mica. These inorganic fillers may be used alone or in combination. Among them, silica, alumina, and titania have low dielectric constants and as such, can reduce permittivity and dissipation factor in the resin layer while lowering a difference in thermal expansion coefficient between the resin layer and the metal layer. According to an embodiment, the inorganic filler may include aluminum hydroxide (ATH), magnesium oxide (MgO), and silica dioxide (SiO₂). In this regard, mix ratios of aluminum hydroxide (ATH), magnesium oxide (MgO), and silica dioxide (SiO₂) (ATH : MgO : SiO₂) may be 40-60 : 30-20 : 30-20 by weight.

Sizes (mean diameters), shapes, and contents of the inorganic filler are important parameters that have influence on characteristics of the adhesive layer.

Specifically, the inorganic filler may range in mean diameter (D50) from about 1 to 10 µm, specifically from about 1 to 5 µm. These sizes are advantageous for dispersibility of the inorganic filler.

In addition, the shape of the inorganic filler is not particularly limited and may be, for example, sphere, flake, dendrite, cone, pyramid, or amorphous.

In the present disclosure, one species of inorganic fillers which are constant in shape and mean diameter may be used alone or two or more species of inorganic fillers which are different in shape and mean diameter may be used in mixture.

In the adhesive composition of the present disclosure, the content of the inorganic filler is not particularly limited, but may be appropriately adjusted in consideration of mechanical properties such as insulation, heat resistance, strength, etc., and low stress. However, an excessive amount of the inorganic filler degrades fluidity and filling property as well as adhesiveness in the adhesive layer. For example, the content of the inorganic filler may be about 15 to 35 parts by weight, based on 100 parts by weight of the adhesive composition.

### (d) Curing agent

The adhesive composition of the present disclosure may further comprise a curing agent. The curing agent is a component that functions to cure the epoxy resin, nitrile-butadiene rubber, and acrylic rubber.

Any curing agent typically known in the art may be used in the present disclosure, as exemplified by acid anhydride-based curing agents, amine-based curing agent, and phenol-based curing agents.

Concrete examples of the curing agent include acid anhydride curing agents such as tetrahydrophthalic anhydride, methyl tetrahydrophthalic anhydride, methyl hexahydrophthalic anhydride, hexahydrophthalic anhydride, trialkyl tetrahydrophthalic anhydride, methyl cyclohexene dicarboxylic anhydride, phthalic anhydride, maleic anhydride, pyromellitic anhydride, etc.; aromatic amine-based curing agents such as methaphenylene diamine, diaminodiphenyl methane, diaminodiphenyl sulphone, etc.; aliphatic amine-based curing agents such as diethylene triamine, triethylene tetraamine, etc.; phenol-based curing agents such as phenol aralkyl-type phenol resins, phenol novolac-type phenol resins, xyloc-type phenol resins, cresol novolac-type phenol resins, naphthol-type phenol resins, terpene-type phenol resins, multifunctional phenol resins, dicyclopentadiene-based phenol resins, naphthalene-type phenol resins, novolac-type phenol resin synthesized from bisphenol A and resole; and potential curing agents such as dicyandiamide, etc., but are not limited thereto. These curing agents may be used alone or in combination.

The content of the curing agent may be about 1 to 10 parts by weight, specifically about 1 to 6 parts by weight, based on 100 parts by weight of the adhesive composition.

### (e) Curing accelerator

The adhesive composition of the present disclosure may further comprise a curing accelerator as necessary. The curing accelerator is a catalyst for shortening a curing time so as to completely cure components in the adhesive composition. Any curing agent typically known in the art may be employed with no particular limitations thereto. For example, imidazole-based curing accelerators, phosphonium-based curing accelerators, amine-based curing accelerators, metal-based curing accelerators, etc. may be used alone or in mixture.

Non-limiting examples of the imidazole-based curing accelerator available in the present disclosure include imidazole, 2-methylimidazole, 2-ethylimidazole, 2-decylimidazole, 2-heptyl imidazole, 2-iso propylimidazole, 2-undecyl imidazole, 2-heptadecyl imidazole, 2-methyl-4-methyl imidazole, 2-ethyl-4-methyl imidazole, 2-phenylimidazole, 2-phenyl-4-methyl imidazole, 1-benzyl-2-methyl imidazole, 1-benzyl-2-phenyl imidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecyl-imidazole trimellitate, 1-cyanoethyl-2-phenyl imidazole trimellitate, 2,4-diamino-6-(2'-methylimidazole-(1')-ethyl-s-triazine, 2-phenyl-4,5-dihydroxy methylimidazole, 2-phenyl-4-methyl-5-hydroxymethylimidazole, 2-phenyl-4-benzyl-5-hydroxymethylimidazole, 4,4'-methylene-bis-(2-ethyl-5-methylimidazole), 2-aminoethyl-2-methyl imidazole, 1-cyanoethyl-2-phenyl-4,5-di(cyanoethoxy methyl)imidazole, 1-dodecyl-2-methyl-3-benzylimidazolium chloride, and imidazole-containing polyamide.

Non-limiting examples of the phosphonium-based curing agent include benzyl triphenylphosphonium chloride, butyl triphenylphosphonium chloride, butyl triphenylphosphonium bromide, ethyl triphenylphosphonium acetate, ethyl triphenylphosphonium bromide, ethyl triphenylphosphonium iodide, tetraphenylphosphonium bromide, tetraphenylphosphonium chloride, and tetraphenylphosphonium iodide.

Non-limiting examples of the amine-based curing accelerator include triethylamine, triethylene diamine, tetramethyl-1,3-butanediamine, ethyl morpholine, diazabicycloundecene, and diazabicyclo nonene.

As the metal-based curing accelerators, organic metal complexes or organic metal salts of cobalt, copper, zinc, nickel, manganese, tin, etc. may be used. Examples of the organic metal complexes include organic cobalt complexes such as cobalt (II) acetylacetonate, cobalt (III) acetylacetonate, etc., organic copper complexes such as copper (II) acetylacetonate, etc., organic zinc complexes such as zinc (II) acetylacetonate, etc., organic iron complexes, such as iron (III) acetylacetonate, etc., organic nickel complexes such as nickel (II) acetylacetonate, etc., organic manganese complexes such as manganese (II) acetylacetonate, etc., but are not limited thereto. Examples of the organic metal salt include zinc octoate, tin octoate, zinc naphthenate, cobalt naphthenate, tin stearate, zinc stearate, etc., but are not limited thereto.

A content of the curing accelerator may be about 0.001 to 10 parts by weight, particularly about 0.001 to 5 parts by weight, more particularly about 0.01 to 1 part by weight, based on 100 parts by weight of the adhesive composition.

### (f) Solvent

The adhesive composition of the present disclosure may further comprise a solvent as necessary.

The solvent available in the present disclosure is not particularly limited as long as it can readily dissolve other substances without participation into reactions. Preferable is a solvent that can easily vaporize in a drying step. For instance, solvents of ketones, esters, alcohols, and esters known in the art may be used. More concrete examples of the solvent include toluene, xylene, methyl ethyl ketone, propylene glycol, monomethyl ether acetate, benzene, acetone, tetrahydrofuran, dimethyl formaldehyde, cyclohexanone, methanol, and ethanol. These solvents may be used alone or in combination thereof.

The solvent can control contents of solid components so that the adhesive composition in a liquid state has a viscosity of about 8,000 cps or less, particularly about 500-5,000, and more particularly about 2,000 to 3,500 cps. For example, it is proper to adjust the solid content into a range of about 28 to 36 % by weight. Thus, the adhesive composition exhibits an improvement in coatability on the substrate of the coverlay film and thus in working efficiency. In addition, a uniform adhesive layer can be formed on the surface of the substrate.

### (g) Additive

The adhesive composition according to the present disclosure may further comprise an additive typically known in the art, as needed, according to the use purpose and condition thereof in addition to the aforementioned ingredients. Examples of the additive include a rubber crosslinking agent, a silane coupling agent, a leveling agent, and an antistatic agent, but are not limited thereto.

The content of the additive is not particularly limited, but may be in a typical range. For example, the additive may be used in an amount of about 0.001 to 10 parts by weight, particularly about 0.01 to 5 parts by weight, and more particularly about 0.01 to 3 parts by weight, based on 100 parts by weight of the adhesive composition.

So long as it is typically known in the art, any rubber crosslinking agent may be used without particular limitations. There are, for example, a vulcanizer, organic peroxide, and so on. It may be concretely exemplified by sulfur, di-(2,4-dichlorobenzoyl)-peroxide, dibenzoyl peroxide, 1,1-di-(tert-butylperoxy)-3,3,5-trimethylcyclohexane, butyl-4,4-di-(tert-butylperoxy) valerate, dicumyl peroxide, di-(2-tert-butylperoxyisopropyl)-benzene, 2,5-dimethyl-2,5-di(tert-butylperoxy)hexyne-3, 2,5-dimethyl-2,5-di-(tert-butylperoxy)-hexane, tert-butyl peroxybenzoate, and di-tert-butylperoxide.

The content of the rubber crosslinking agent may be in the range of about 0.1 to 20 parts by weight, particularly about 0.1 to 10 parts by weight, and more particularly about 1 to 5 parts by weight, based on 100 parts by weight of the adhesive composition.

No particular limitations are imparted to a silane coupling agent available in the present disclosure as long as it is known in the art. Examples of the silane coupling agent include epoxy-, methacryloxy-, amino-, vinyl-, mercaptosulfide-, and ureido-based silane coupling agents. They may be used alone or in combination thereof. Such a silane coupling agent may improve adhesiveness between an inorganic filler and other ingredients when the adhesive adhesion is cured.

The content of the silane coupling agent may be in the range of about 1 to 20 parts by weight, based on 100 parts by weight of the inorganic filler, but with no limitations thereto.

Any leveling agent known in the art may be available in the present disclosure, without particular limitations. Mostly, a fluorine-based leveling agent may be used.

The leveling agent may be used at a content of about 0.01 to 1 part by weight, based on 100 parts by weight of the total solid fraction.

The adhesive composition according to the present disclosure has a curing temperature of about 130°C or higher and particularly about 130 to 200°C.

The adhesive composition according to the present disclosure may have a viscosity of about 8,000 cps or less, particularly about 500-5,000 cps, and more particularly about 2,000-3,500 cps at room temperature (specifically at 25-30°C). In this regard, the adhesive composition may have improved coatability, which leads to an increase in working efficiency, and can be formed into an adhesive layer constant in thickness on the surface of a substrate.

The adhesive composition of the present disclosure may be prepared using a method typically known in the art. For example, an adhesive composition may be prepared by mixing and stirring an epoxy resin; a binder resin including acrylonitrile-butadiene rubber and acrylic rubber; and an inorganic filler, optionally together with a curing agent, a curing accelerator, a solvent, and an additive (e.g., rubber crosslinking agent, etc.), at room temperature to an appropriately elevated temperature in a mixing device, such as a ball mill, a bead mill, a 3-roll mill, a basket mill, a dyno mill, a planetary, etc.

The adhesive composition of the present disclosure is superb in terms of fluidity, filling property (landfilling), insulation, heat resistance, migration resistance, discoloration resistance, moisture resistance, chemical resistance, dimensional stability, and moldability as well as adhesiveness.

### <Coverlay film>

The present disclosure provides a coverlay film using the adhesive composition.

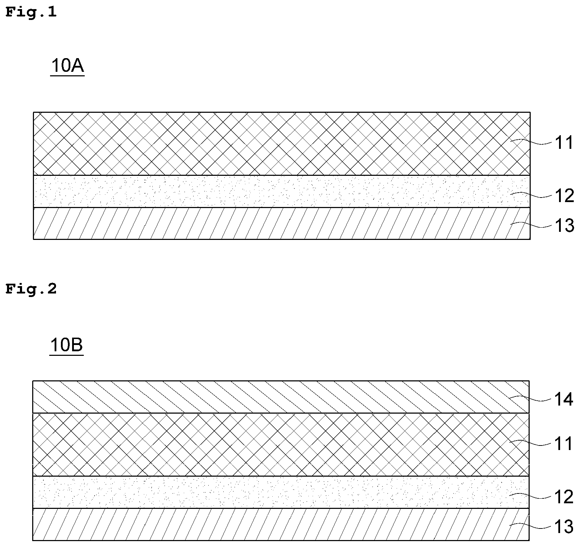

FIG. 1 is a schematic cross-sectional view of a coverlay film according to a first embodiment of the present disclosure and FIG. 2 is a schematic cross-sectional view of a coverlay film according to a second embodiment of the present disclosure.

The coverlay film (10A, 10B) according to the present disclosure, which is designed to protect a printed circuit board, specifically a circuit on a printed circuit board, comprises: a base substrate (11); an adhesive layer (12) disposed on one surface of the substrate and formed of the adhesive composition; and a release film (13) disposed on the adhesive layer. Optionally, the coverlay film may further comprise a surface protection film (14) disposed on the other surface of the base substrate (11).

With reference to FIG. 1, the coverlay film (10A) according to a first embodiment of the present disclosure will be elucidated, below.

As shown in FIG. 1, the coverlay film (10A) according to a first embodiment of the present disclosure has a structure in which a base substrate (11), an adhesive layer (12), and a release film (13) are sequentially laminated.

### 1) Base substrate

In the coverlay film (10A) according to the present disclosure, the base substrate (11) is attached to the printed circuit board via the adhesive layer (12) to protect a circuit in the printed circuit board.

According to an embodiment, the base substrate (11) may be an insulative substrate. In this regard, the coverlay film may secure a low dielectric property.

So long as it is typically known in the art, any plastic film may be used as the base substrate (11), without limitations. Examples of the base substrate include polyester films, such as polyethylene terephthalate (PET), polybutylene terephthalate, polyethylene naphthalate, etc., polyethylene films, polypropylene films, cellophane, diacetyl cellulose films, triacetyl cellulose films, acetyl cellulose butyrate films, polyvinyl chloride films, polyvinylidene chloride films, polyvinyl alcohol films, ethylene-vinyl acetate copolymer films, polystyrene films, polycarbonate films, polymethylpentene films, polysulfone films, polyether ether ketone films, polyether sulfone films, polyether imide films, polyimide films, fluorine resin films, polyamide films, acrylic resin films, norbornene-based resin films, and cycloolefin resin films. Such a plastic film may be transparent or semi-transparent or may or may not be colored. According to an embodiment, the base substrate (11) may be polyethylene terephthalate (PET). According to another embodiment, the base substrate (11) may be polyimide (PI).

The thickness (T1) of the base substrate is not particularly limited and may be, for example in the range of about 5 to 50 µm.

### 2) Adhesive layer

In the coverlay film (10A) according to the present disclosure, the adhesive layer (12) is disposed on one surface of the base substrate (11) to attach the coverlay film (10A) to the surface of the printed circuit board.

The adhesive layer (12) of the present disclosure includes is in a semi-cured state and includes a cured substance formed from the adhesive composition. In this regard, the adhesive layer (12) may have a degree of crosslinking (gelation) of about 40-80 %, and particularly about 40-70 %.

In the present disclosure, the adhesive composition comprises an epoxy, a binder resin, and an inorganic filler, wherein the binder resin includes nitrile-butadiene rubber and acrylic rubber at specific ratios. Thus, beings controlled to range in viscosity from about 500 to 8,000 cps (particularly about 1,000-8,000 cps, more particularly about 1,000-3,000 cps, and even more particularly about 1,000-1,500 cps) at a temperature of 140-160°C, the adhesive layer of the present disclosure exhibits excellent fluidity and filling properties (landfilling) .

As such, the adhesive layer (12) of the present disclosure can reduce a time of a hot press process by about 5-6 folds due to the excellent fluidity thereof, enhancing a process efficiency, compared to conventional coverlay films. In addition, exhibiting excellency in terms of filling performance within about 55-66 seconds, the adhesive layer (12) of the present disclosure can suppress a defective caused by a void between the coverlay film and the printed circuit board. Furthermore, the adhesive layer (12) of the present disclosure is superb in migration resistance and discoloration resistance as well as adhesiveness, thus allowing the coverlay film to protect the printed circuit board and minimizing the formation of a short circuit on the printed circuit board. In addition, the adhesive layer can improve the reliability of the printed circuit board due to the excellent heat resistance, moisture resistance, and chemical resistance thereof.

No particular limitations are imparted to the thickness of the adhesive layer. For example, the adhesive layer may be about 10-50 µm thick. Given the thickness range, the adhesive layer can enhance film formability, thickness uniformity, etc..

### 3) Release film

In the coverlay film (10A) according to the present disclosure, the release film (13) is disposed on the adhesive layer (12) to prevent the adhesive layer (12) to be contaminated with impurities from the outside environment before application of the coverlay film to the printed circuit board. The release film is released and removed before the coverlay film is applied to one or both sides of the printed circuit substrate.

So long as it is released without any damage on the adhesive layer (12), any release film known in the art may be used as the release film (13). For example, a fluorine release film, specifically, a fluorosilicone release film containing a platinum catalyst, a fluorine release film having a fluorine curing agent and an adhesive additive mixed with each other, etc. may be used.

No particular limitations are imparted to the release power of the release film. For example, the release power of the release film against the adhesive layer may be about 20 to 90 gf/inch as measured according to ASTM D3330.

In addition, the thickness of the release film is not particularly limited. For example, the thickness ratio of the release film (T2) to the adhesive layer (T3)

### (T3/T2) may be about 3 to 5.

Below, the coverlay film (10B), shown in FIG. 2, according to a second embodiment of the present disclosure will be elucidated.

As shown in FIG. 2, the coverlay film (10B) according to the second embodiment of the present disclosure comprises: a base substrate (11); an adhesive layer (12) disposed on one surface of the base substrate and formed of the adhesive composition; a release film (13) disposed on the adhesive layer (12); and a surface protection film (14) disposed on the other surface of the base substrate (11) .

Since the base substrate (11), the adhesive layer (12), and the release film (13) in the coverlay film (10B) according to the second embodiment are the same as in the first embodiment, elucidations thereof are omitted.

In the coverlay film (10B) according to the second embodiment, the surface protection film (14) is disposed on the other surface (specifically, the outside surface) of the base substrate (11), to prevent the base substrate (11) from being contaminated with external foreign matter and to protect the surface of the film, particularly the surface of the substrate when the coverlay film is attached to the printed circuit board by a hot press process. This surface protection film (14) may be released and eliminated, as necessary, upon application of the coverlay film to the printed circuit board.

Any protection film typically known in the art may be used as the surface protection film, without particular limitations. Examples of the surface protection film include polyester films such as polyethylene terephthalate (PET), polybutylene terephthalate, polyethylene naphthalate, etc., polyethylene films, polypropylene films, cellophane, diacetyl cellulose films, triacetyl cellulose films, acetyl cellulose butyrate films, polyvinyl chloride films, polyvinylidene chloride films, polyvinyl alcohol films, ethylene-vinyl acetate copolymer films, polystyrene films, polycarbonate films, polymethylpentene films, polysulfone films, polyether ether ketone films, polyether sulfone films, polyether imide films, polyimide films, fluorine resin films, polyamide films, acrylic resin films, norbornene-based resin films, and cycloolefin resin films, but are not limited thereto.

In addition, at least one surface of the surface protection film (14), specifically the surface in contact with the base substrate (11) may be matt. In this regard, the matt surface of the surface protection film (14) may have a release power of about 30 to 100 gf/inch against the base substrate. This surface protection film (14) may be easily peeled off and removed from the coverlay film after the coverlay film is attached to a flexible printed circuit board.

Furthermore, the thickness of the surface protection film is not particularly limited and may be, for example, about 20 to 80 µm and specifically about 40 to 60 µm.

The coverlay films (10A, 10B) of the present disclosure may be prepared using a typical method known in the art, except for the formation of the adhesive layer from the adhesive composition.

In the method for preparing a coverlay film according to an embodiment of the present disclosure, the adhesive composition is applied to one surface of the base substrate and thermally set to form an adhesive layer and a release film is then disposed and laminated on the adhesive layer, followed by laminating a surface protection film on the other surface of the base substrate, as necessary.

The adhesive composition may be coated using a typical coating method known in the art, for example, dip coating, air knife coating, curtain coating, wire bar coating, gravure coating, comma coating, slot coating, extrusion coating, spin coating, slit scanning, and inkjet coating.

The thermosetting process may be appropriately carried out in a typical condition known in the art. For example, thermosetting may be conducted for about 5-10 min at about 130°C or higher (particularly about 130-200°C and more particularly about 130-150°C). The adhesive layer formed through the thermosetting process is in a semi-cured state with a degree of crosslinking of about 40-80 %.

As described above, the coverlay film of the present disclosure comprises an adhesive layer superb in adhesiveness, fluidity, filling property (landfilling), migration resistance, discoloration resistance, heat resistance, moisture resistance, and chemical resistance and, upon manufacture of a printed circuit board, thus can enhance the efficiency of the hot press process, decrease the defective rate of the printed circuit board, and increase the reliability of the printed circuit board.

### <Printed circuit board>

The present disclosure provides a printed circuit board comprising the coverlay film described above.

According to an embodiment, the printed circuit board of the present disclosure comprises: a board body; and the coverlay film (10A, 10B) disposed on at least one surface of the board body. In this regard, the adhesive layer (12) of the coverlay film (10A, 10B) exhibits excellent fluidity and filling property. Thus, voids between the coverlay film (10A, 10B) and the board body are about 0% as inspected for appearance by a 60x magnification microscope. In addition, the printed circuit board of the present disclosure exhibits excellent reliability because of the superb heat resistance, moisture resistance, and discoloration resistance of the coverlay film (10A, 10B).

A better understanding of the present disclosure may be obtained via the following examples which are set forth to illustrate, but are not to be construed as limiting the present disclosure.

### [EXAMPLE 1]

### 1-1. Preparation of adhesive composition

Adhesive composition (viscosity: about 2,500 cps) were prepared by mixing the ingredients according to the compositions listed in Table 1, below. In Table 1, the content units are parts by weight for epoxy resin, NBR, acrylic resin, inorganic filler, curing agent, and curing accelerator and are based on 100 parts by weight of a total of the epoxy resin and the binder resin.

### 1-2. Preparation of coverlay film

The adhesive composition prepared in Example 1-1 was applied to one surface of a polyethylene terephthalate film (thickness: about 25 µm), which is a base substrate, followed by thermosetting at about 150°C for about 5 min to form adhesive layers (degree of crosslinking: about 40%, thickness: about 35 µm). Thereafter, a fluorine-based release film (thickness: about 120 µm) was laminated on the adhesive layer to afford a coverlay film.

### [EXAMPLE 2 AND COMPARATIVE EXAMPLES 1-5]

Adhesive compositions and coverlay films of Example 2 and Comparative Examples 1-5 were prepared in the same manner as in Example 1, with the exception of mixing individual ingredients according to the compositions listed in Table 1.

**TABLE 1**

| | | Ex. 1 | Ex. 2 | Ex. 3 | Ex. 4 | Ex. 5 | Ex. 6 | C. Ex. 1 |
|---|---|---|---|---|---|---|---|---|
| Epoxy resin | | 40 | 40 | 20 | 30 | 40 | 50 | 60 |
| Binder resin | NBR | 20 | 10 | 40 | 35 | 30 | 40 | 20 |
| | Acrylic rubber | 40 | 50 | 40 | 35 | 30 | - | 20 |
| Inorganic filler | | 28 | 28 | 28 | 28 | 28 | 28 | 20 |
| Curing agent | | 4 | 4 | 2 | 3 | 4 | 5 | 6 |
| Curing accelerator | | 1 | 1 | 0.5 | 0.75 | 1 | 1.25 | 1.5 |
| Viscosity (cps) | | 2, 500 | 3,000 | 1,100 | 1,800 | 5,000 | 8,000 | 15,000 |
| * Epoxy resin: bisphenol A epoxy resin (epoxy equivalent: 475 g/eq) | | | | | | | | |
| * NBR: XER-32 (JSR) | | | | | | | | |
| * Acrylic rubber: Vamac^{®} (Dupont) | | | | | | | | |
| * Inorganic filler: mixture of aluminum hydroxide (ATH) (D50: 3 µm), magnesium oxide (MgO) (D50: 3 µm), and silicon dioxide (SiO₂) (D50: 3 µm) (ATH : MgO : SiO₂ = 50 : 25 : 25 by weight) | | | | | | | | |
| * Curing agent: diamino diphenyl sulfone | | | | | | | | |
| * Curing accelerator: imidazole catalyst (2methyl 4-methylimidazole) used | | | | | | | | |

### [EXPERIMENTAL EXAMPLE 1] - Evaluation for Physical Property

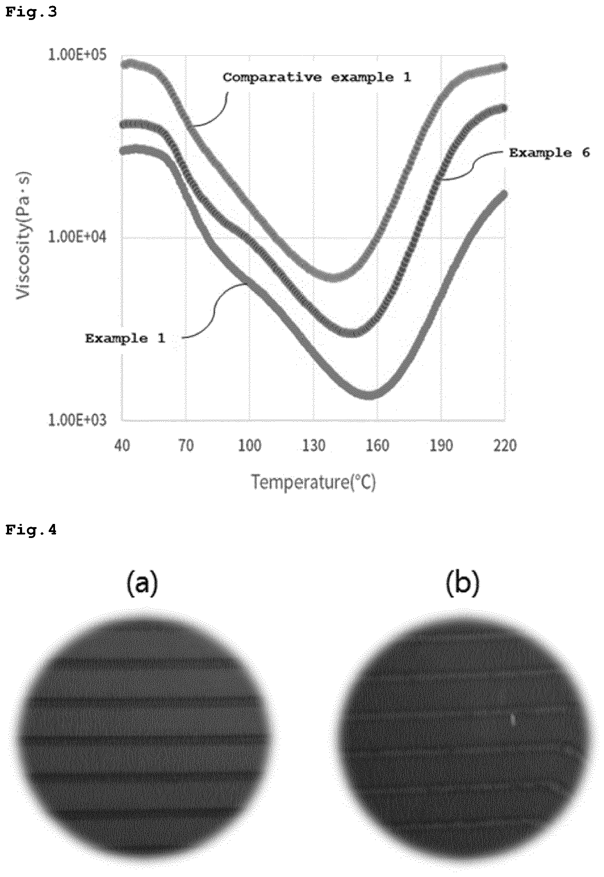

Physical properties of the coverlay films prepared in Examples 1-6 and Comparative Example 1 were evaluated as follows, and the results are shown in Table 2, below, and FIGS. 3-4.

### 1) Viscosity

The adhesive layers in the coverlay films were measured for viscosity, using a rheometer, and the results are shown in Table 2 and FIG. 3.

### 2) Filling property

The coverlay films (release films removed) were hot pressed against printed circuit boards (circuit patterns: 35 µm in thickness, 100 µm in width, and 100 µm in spacing therebetween) at a temperature of 180°C under a pressure of 5,400 LB for 45 sec. The time points at which spaces between patterns of the printed circuit boards were filled with the adhesive layers of the coverlay films were determined while the coverlay films were pressed over time. The results are shown in Table 2 and FIG. 4.

### 3) Solder Floating (S/F)

The coverlay films (release films removed) were hot pressed against printed circuit boards (circuit patterns: 35 µm in thickness, 100 µm in width, and 100 µm in spacing therebetween) at a temperature of 180°C under a pressure of 5,400 LB for 45 sec to afford products. Thereafter, the products were floated for 10 sec in a solder bath maintained at 300°C and then examined for the occurrence of blaster or interlayer delamination on the appearance thereof. Here, the occurrence of blaster/interlayer delamination on the appearance of the product is expressed as "Fail".

### 4) Discoloration

The coverlay films (release films removed) were hot pressed against printed circuit boards (circuit patterns: 35 µm in thickness, 100 µm in width, and 100 µm in spacing therebetween) at a temperature of 180°C under a pressure of 5,400 LB for 45 sec to afford products. Thereafter, the products were left for 24 hours under the conditions of 85°C and 85% RH and then examined for change in color, compared to the initial state. Here, a change in color, if occurring, was expressed as "Fail".

### 5) CAF Test

The coverlay films (release films removed) were hot pressed against printed circuit boards (circuit patterns: 35 µm in thickness, 100 µm in width, and 100 µm in spacing therebetween) at a temperature of 180°C under a pressure of 5,400 LB for 45 sec to afford products. After application of a voltage of 5V to the products for 168 hours under the conditions of 85°C and 85% RH, examination was made of resistance changes in the products. In this regard, the resistance of the products which decreased to 10⁶ Ω or less was expressed as "Fail".

Here, CAF tests for Comparative Example 1 was not conducted as the filling time point exceeded 100 sec upon testing filling properties.

**TABLE 2**

| | Viscosity (cps) | Filling (sec) | S/F (@300°C) | Discoloration (@85/85/24) | CAF Test |
|---|---|---|---|---|---|
| Ex. 1 | 1,100 | 45 | Pass | Pass | Pass |
| Ex. 2 | 1,300 | 45 | Pass | Pass | Pass |
| Ex. 3 | 500 | 30 | Pass | Pass | Pass |
| Ex. 4 | 700 | 30 | Pass | Pass | Pass |
| Ex. 5 | 1,000 | 45 | Pass | Pass | Pass |
| Ex. 6 | 3,000 | 90 | Pass | Pass | Pass |
| C. Ex. 1 | 6,000 | 120 | Fail | Fail | - |

### [EXPERIMENTAL EXAMPLE 2] - Filling Property Test of Coverlay Film

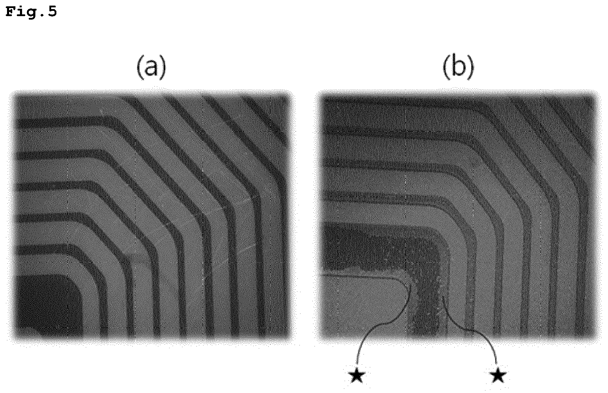

The coverlay films prepared in Example 1 were tested for filling property as follows, and the results are depicted in FIG. 5.

The coverlay films (release films removed) were hot pressed against printed circuit boards (circuit patterns: 35 µm in thickness, 100 µm in width, and 100 µm in spacing therebetween) at a temperature of 180°C under a pressure of 5,400 LB for 45 sec, after which the filling appearances of the coverlay films for patterns of the printed circuit boards were examined. As a control, DC-200 from Doosan Cooperation Electro-Materials was used.

For printed circuit boards to which the coverlay film of Example 1 was applied, spacings between the patterns were sufficiently filled with the adhesive layer [see FIG. 5(a)]. In contrast, the printed circuit board to which the control DC-200 was applied was found to have parts in which spaces between patterns were not filled with the adhesive layer [yellow parts ('★' marked)] [see FIG. 5(b)].

## Claims

1. An adhesive composition, comprising: an epoxy resin; a binder resin including at least one species of rubber; and an inorganic filler, and having a viscosity of 8,000 cps or less.

2. The adhesive composition of claim 1, wherein the binder resin comprises nitrile-butadiene rubber and acrylic rubber.

3. The adhesive composition of claim 2, wherein the nitrile-butadiene rubber and the acrylic rubber are contained at a weight ratio of 1 : 1.5-7.

4. The adhesive composition of claim 2, wherein the nitrile-butadiene rubber is contained at a content of 10 to 25 parts by weight, based on 100 parts by weight of the adhesive composition.

5. The adhesive composition of claim 1, wherein the epoxy resin ranges in epoxy equivalent (EEW) from 100 to 500 g/eq.

6. The adhesive composition of claim 1, wherein the adhesive composition has a curing temperature of 130°C.

7. The adhesive composition of claim 1, comprising:
5 to 50 parts by weight of the epoxy resin,
30 to 60 parts by weight of the binder resin, and
15 to 35 parts by weight of the inorganic filler, based on 100 parts by weight of the adhesive composition.

8. A coverlay film, comprising:
a base substrate;
an adhesive layer disposed on one surface of the base substrate and formed of the adhesive composition of any one of claims 1 to 7; and
a release film disposed on the adhesive layer.

9. The coverlay film of claim 8, wherein the adhesive layer ranges in viscosity from 500 to 8,000 cps at a temperature of 140-160°C.

10. The coverlay film of claim 8, wherein the adhesive layer has a degree of crosslinking of 40-80 %.

11. The coverlay film of claim 8, further comprising a surface protection film disposed on another surface of the base substrate.

12. A printed circuit board, comprising:
a board body; and
a coverlay film, disposed on at least one surface of the substrate, of any one of claims 8 to 11.
